# EUROPEAN PATENT SPECIFICATION

(11) **EP 1 238 424 B1**
(45) Date of publication and mention of the grant of the patent: **23.03.2011**
(21) Application number: 00983610.7
(22) Date of filing: 29.11.2000
(51) Int. Cl.: H01L 21/8222, H01L 29/732, H01L 29/06, H01L 21/331

(54) **METHOD OF MAKING A COLLECTOR-UP BIPOLAR TRANSISTOR**
VERFAHREN ZUM HERSTELLEN EINES BIPOLARTRANSISTORS MIT OBENLIEGENDEM KOLLEKTOR
METHODE DE FABRICATION D'UN TRANSISTOR BIPOLAIRE A COLLECTEUR SITUÉ AU-DESSUS

(30) Priority: 02.12.1999 SE 9904383
(43) Date of publication of application: 11.09.2002
(73) Proprietor: Infineon Technologies AG, 85579 Neubiberg (DE)
(72) Inventor: ARNBORG, Torkel, S-114 36 Stockholm (SE); JOHANSSON, Ted, S-182 62 Djursholm (SE)
(74) Representative: Fritzon, Rolf
(86) International application number: PCT/SE2000/002365
(87) International publication number: WO 2001/041210

(56) References cited:
- EP-A1- 0 794 565
- US-A- 5 798 539
- ANDREAS GRUHLE ET AL.: 'Collector-up SiGe heterojunctions bipolar transistors' IEEE TRANSACTIONS ON ELECTRON DEVICES vol. 46, no. 7, July 1999, pages 1510 - 1513, XP002937232

## Description

### TECHNICAL FIELD

The present invention relates to bipolar transistors and the fabrication thereof and particularly to bipolar high-frequency transistors.

### BACKGROUND

Bipolar high-frequency transistors are typically used for power amplification and are widely used in output parts of communications system. The devices need to meet numerous detailed requirements for breakdown voltages, DC beta, capacitances, RF gain, ruggedness, noise figure, input/output impedance, distortion etc. The operating frequency range from several hundred MHz into the GHz region. The output power requirements range from a few watts up to several hundred watts, using many paralleled devices in one package. Power transistors operate at large signal levels and high current densities.

The transistor structure is usually vertical with the collector contact on the silicon substrate's backside. The collector layer is epitaxially deposited on the substrate. The base and emitter are formed by diffusion or ion implantation at the top the epitaxial layer. By varying the doping profiles, it is possible to achieve different frequency and breakdown voltage characteristics.

One parameter of great interest in communications is distortion. Linearity of the transistors or lack of distortion determines some important parameters for the communication systems, such as interference with adjacent channels, thus determining the frequency margin necessary between nearby channels. Making systems more linear can be made on each level of the system: device, circuit, circuit board, sub-system, system, etc. Here we are concerned only with improvements at the device level.

Distortion arises when the magnitude of the output signal is not exactly proportional to the input signal. Active semiconductor devices (bipolar devices or FET devices) will always produce non-linear output because of the non-linear input/output characteristics and due to internal and external parasitic elements when switching at high frequency. The non-linearity of a bipolar device is more complex than of a FET due to the exponential input/output relationship. The fundamental relationship of the input/output signals can not be manipulated without changing materials of the device.

Reduction of device capacitance is easier to achieve. The most important capacitances for power transistor linearity are those on the output side of the transistor, which capacitances mainly consist of a base-collector capacitance (junction type, voltage dependent) and a metal-substrate parasitic capacitance (MOS type, voltage independent).

Since a junction capacitance is non-linear in its nature, it generates a number of non-linearities and over-tones in the frequency spectrum when the voltage over the junction changes. During power operations (large-signal switching), the voltage over the B-C junction varies from around zero up to two times the supply voltage giving around a factor of four in base-collector capacitance variation.

Distortion problems can be handled by circuit techniques like predistortion and feedback to some additional, maybe substantial, cost. However non-linearity in reactive components are much more difficult to compensate for since time dependence is involved. Especially the collector-base capacitance in a bipolar transistor is critical because it is the dominant reactive non-linearity. Methods to reduce the distortion at the device level are therefore needed.

In an international patent application WO99/12211 also assigned to Telefonaktiebolaget LM Ericsson the present inventors presents a method to reduce the collector-base capacitance ratio during large signal switching. A variation in the doping level of the epitaxial collector layer is described, reducing the large signal dCBc/dV, thus improving the linearity during large-signal amplification. The doping is lowest at the surface and is then gradually increased towards the substrate.

However, there is still a demand of obtaining bipolar high-frequency transistor presenting high performance within their operation frequency range, for example, by presenting low capacitance swing as well as high breakdown voltage and still with a reasonable manufacturing technique level.

"Andreas Gruhle et at: Collector-up SiGe Heterojunction Bipolar Transistors" discloses that heterojunction bipolar transistors in collector-up versions have the advantage of a very low collector-base capacitance. In addition, because the substrate is the emitter, extremely low emitter series inductances may be achieved, e.g., in the case of a packaged discrete devices.

This is particularly interesting for RF power amplifiers. Transistors fabricated on MBE-grown layers with an emitter size of 1.6 µm showed near-ideal Gummel plots dc current gains of up to 485, an S₂₁ gain of 20dB at 2 GHz and an fₘₐₓ of 33 GHz. A problem to be solved is the large parasitic C_{BE} capacitance, which degrades the transit frequency.

EP 794 565 Al discloses a method for fabricating an HBT in which the subcollector-base junction, which contributes to the base-collector capacitance of the device, is reduced by using a selective subcollector. In particular, subcollector areas of the device that do not contribute to collector resistance reduction are eliminated, thereby reducing the subcollector area, which, in turn, reduces the base-collector capacitance. As such, the maximum power gain frequency fₘₐₓ is increased.

US 5,798,539 discloses a bipolar transistor for very high frequencies having a delta-p-doped base layer and a drift zone between the base layer and an n⁺-doped collector terminal layer, the drift zone, at least in a base-end region, being made of a material having a split conduction band structure which, in the drift direction, energetically favours light electrons.

### SUMMARY

The present invention disclosure describes a method to reduce the base-collector capacitance swing by shaping the form of the collector of a bipolar collector up high frequency transistor. The collector is designed being made narrow closer to the collector contact, thus improving both the capacitance swing and the breakdown voltage. The present disclosed method also describes a manner in which this is implemented for producing a discrete mesa-etched RF power transistor.

A method according to the present invention is set forth by the independent claim 1 and the dependent claims 2 - 9.

### BRIEF DESCRIPTION OF THE DRAWINGS

The invention, together with further objects and advantages thereof, may best be understood by making reference to the following description taken together with the accompanying drawings, in which:
- FIG. 1: illustrates a new proposed transistor with etched collector region resulting in a decreasing cross section towards the collector contact;
- FIG. 2: illustrates a standard structure with doping contours of a vertical bipolar transistor with collector up;

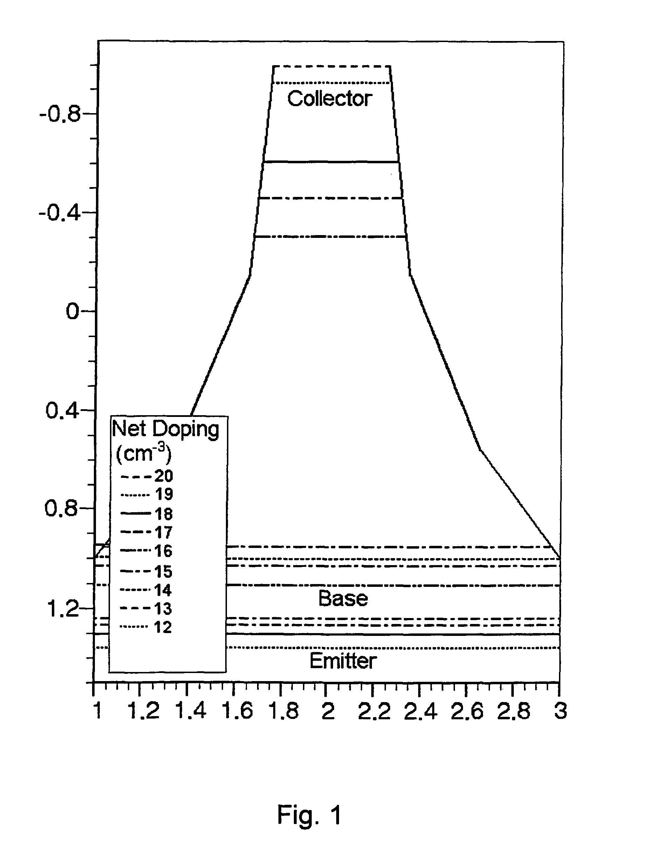

- FIG. 1: illustrates a new proposed transistor with etched collector region resulting in a decreasing cross section towards the collector contact;

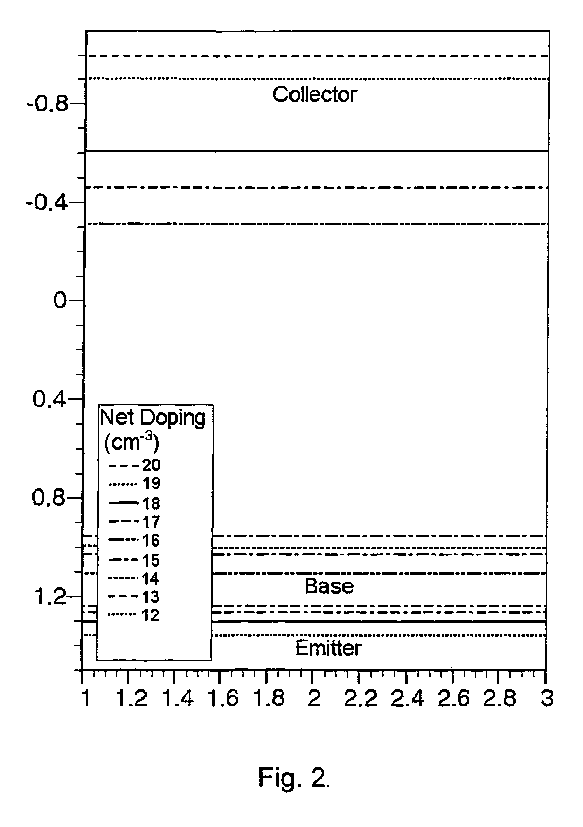

- FIG. 2: illustrates a standard structure with doping contours of a vertical bipolar transistor with collector up;

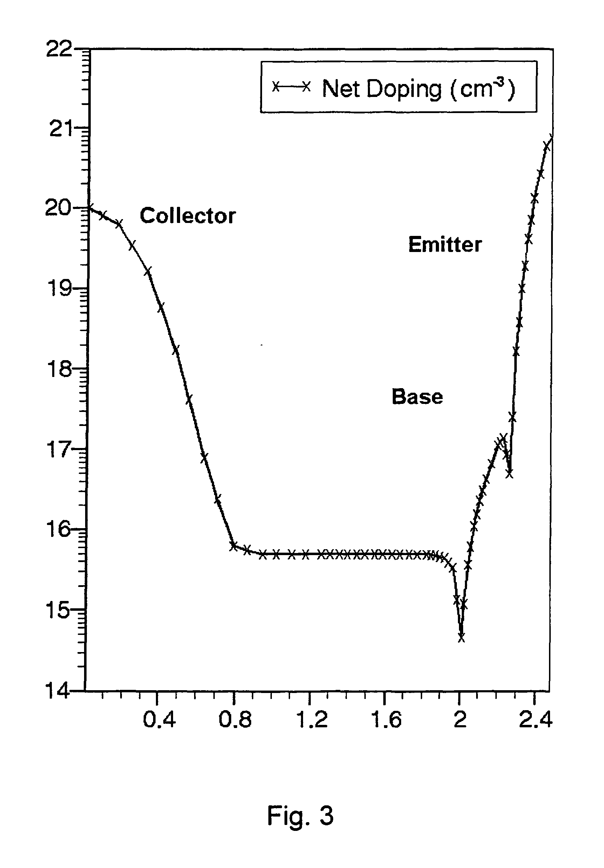

- FIG. 3: illustrates the doping profile used for a standard transistor, the new proposed transistor etched towards the collector (etch-up) and a third structure etched more towards the base-emitter (etch-down);

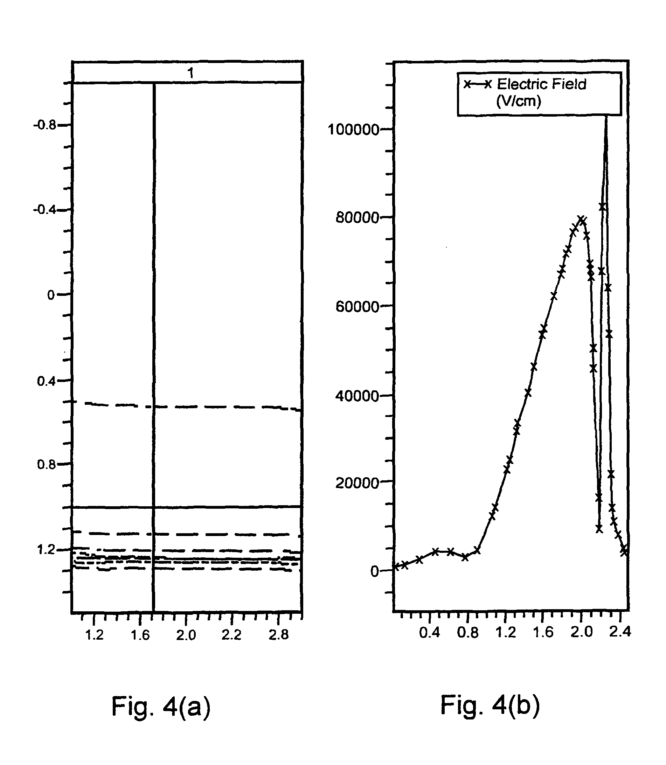

- FIG. 4(a): illustrates a line of symmetry for the standard transistor for an electric field measurement;
- FIG. 4(b): presents the electric field along the symmetry line of the standard transistor of FIG. 4(a);

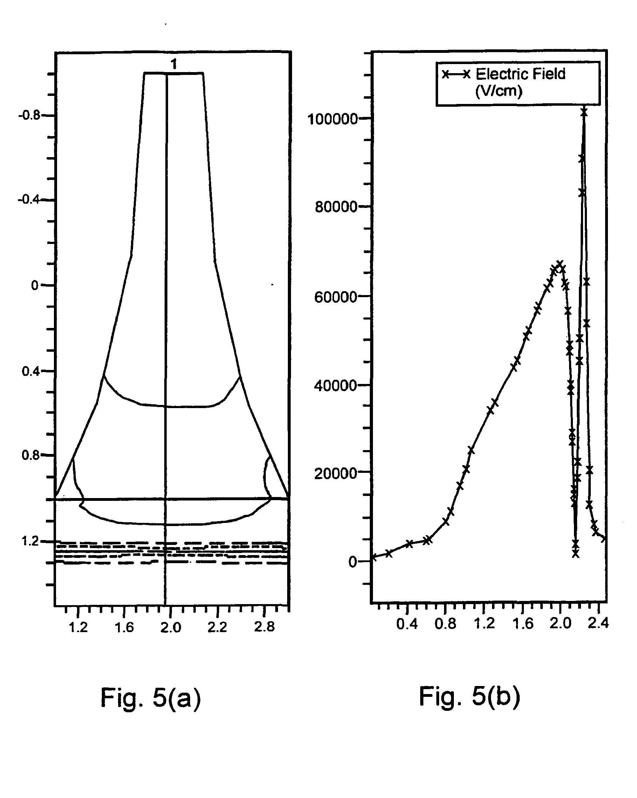

- FIG. 5(a): illustrates a line of symmetry for an 'etch-up' transistor for an electric field measurement;
- FIG. 5(b): presents the electric field along the symmetry line of the 'etch-up' transistor of FIG. 5(a);

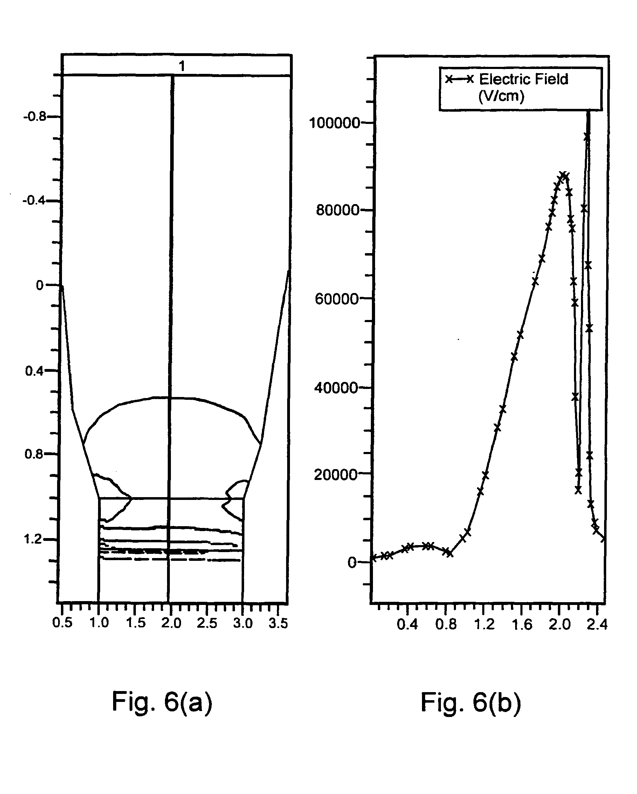

- FIG. 6(a): illustrates a line of symmetry for an 'etch-down' transistor for an electric field measurement;
- FIG. 6(b): presents the electric field along the symmetry line of the 'etch-down' transistor of FIG. 6(a);

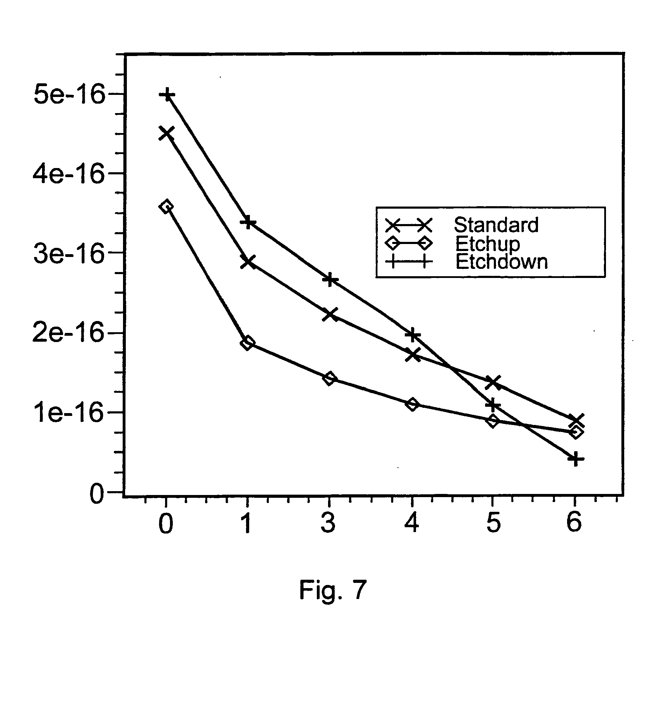

- FIG. 7: demonstrates the collector-base capacitance as a function of collector voltage for the standard, 'etch-up' and 'etch-down' transistors of FIG. 4 to FIG. 6;

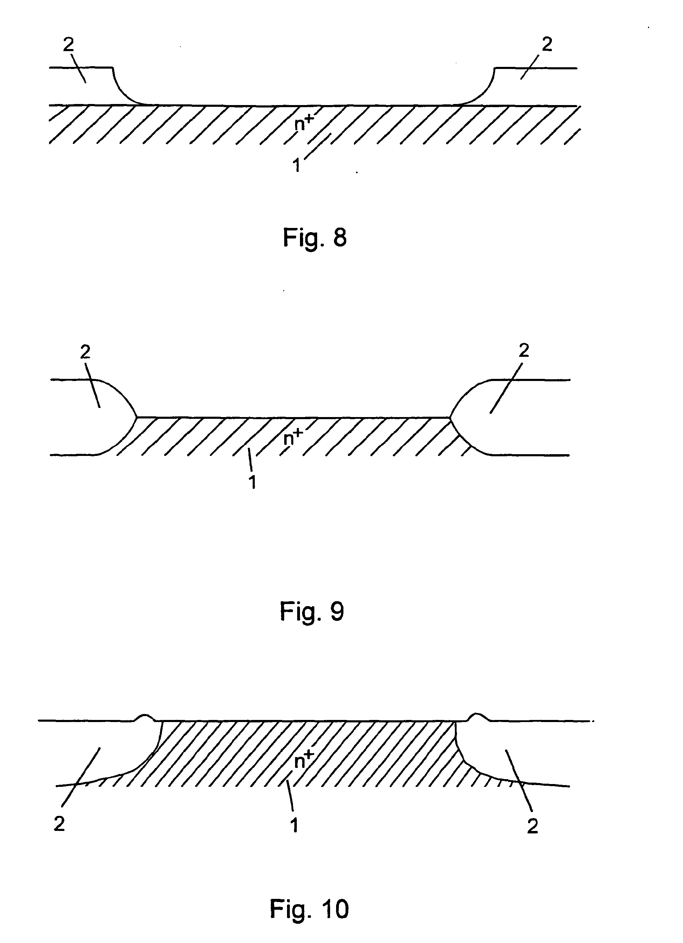

- FIG. 8: illustrates isolation by thermal oxide and wet/dry etch;
- FIG. 9: illustrates isolation by a conventional LOCOS isolation step;
- FIG. 10: illustrates isolation by a recessed LOCOS step;

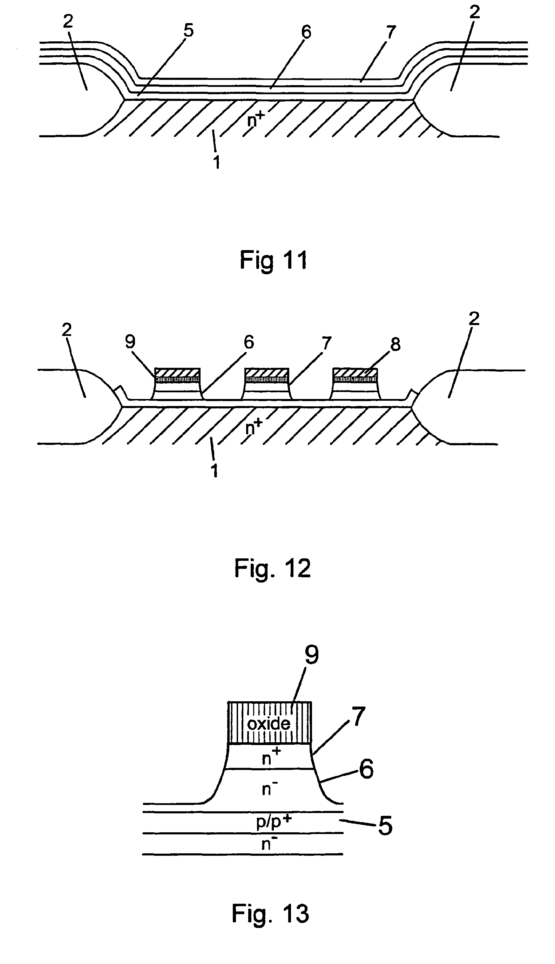

- FIG. 11: illustrates deposit of base/collector structure;
- FIG. 12: illustrates the status after the step of etching base-collector mesa;
- FIG. 13: is a more detailed view of a portion of FIG. 7 but layer of photoresist removed;

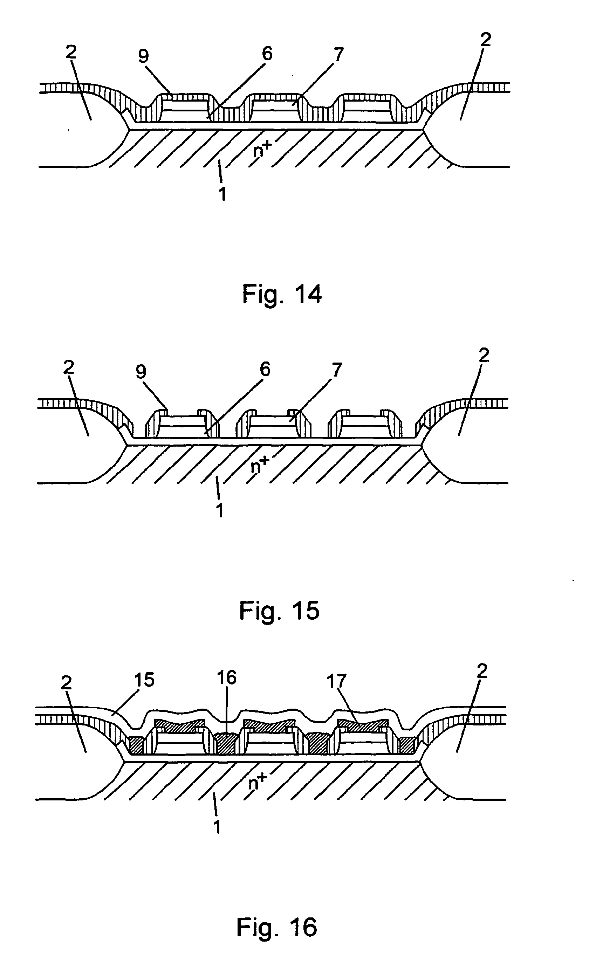

- FIG. 14: illustrates the implantation of BF₂ after forming oxide spacers;
- FIG. 15: illustrates the status after a TEOS deposition and etching of contact holes;
- FIG. 16: illustrates a final metalized and passivated result of the fabrication process according to the present invention; and

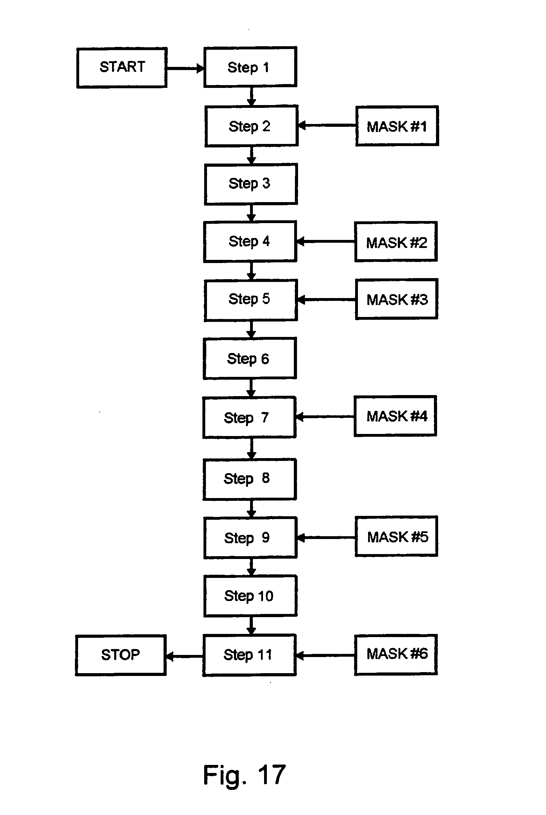

- FIG. 17: demonstrates a flow chart according to the present method.

### DETAILED DESCRIPTION

In the international application W099/ 12211 already mentioned a method is described to reduce the collector-base capacitance ratio during large signal switching by varying the doping level of the epitaxial collector layer.

Another way to approach the same problem would be to change the shape of the collector region so that the collector cross-sectional area is decreasing towards the collector. This will have a significant impact on the electric field distribution because of the boundary conditions. In figure 1 is shown a structure with such a non-rectangular cross-section (the collector has been turned up for reasons explained below). For comparison, a similar transistor with constant cross-section along the base-collector region is shown in figure 2.

At the semiconductor-ambience interface the equipotential lines are perpendicular to the surface assuming that no charges are present here. In the case of etched boundaries, the lines are bent changing the internal field. Data were calculated for three different structures having identical doping profiles, illustrated in figure 3, but with a different slope of the boundaries as shown in Figures 4, 5 and 6. The structures will be referred to as "standard", "etch-up" and "etch-down". The "etch-down" case is included to show that parameters change in a predictive way. Normally the "etch-up" structure is giving the desired improvements in terms of breakdown voltage and linearity.

The desired effect is achieved when the collector gets narrower as the distance from the base junction increases, and by means of 2D computer simulations, we have verified this. In figure 4(a), 5(a) and 6(a) are shown three different shapes of the collector region and the resulting capacitance swing curves are shown in Figures 4(b), 5(b) and 6(b). The most advantageous is the "etch-up" structure. (The "swing" is defined as C(0 V)/C(5 V). A low value is preferable.)

However, the desired shape of the collector is not simple to fabricate, using a normal transistor with the collector extending down towards the substrate. Therefore a reversed structure is suggested forming a single-mesa structure for the fabrication of a discrete bipolar transistor.

Advantages of the reversed structure, referred to as collector-up, are most apparent for discrete RF power components. The primary advantage for GaAs-based heterojunction bipolar transistors (HBT's) has been the reduction of CB-capacitance, and this will also be true for silicon-based devices. One advantage of the silicon techniques, which is difficult to obtain with GaAs, is that the emitter of the silicon component constitutes the (highly doped) silicon substrate, which is simply contacted at the back of the chip. This reduces the well-known problems of emitter inductance due to the bonding wire or wires. GaAs structures are built on a semi-insulating material and are contacted from the chip front side via bonding wires or even through plated pedestals, which also makes it complicated and expensive.

The proposed structure will be described by illustrating an example of a fabrication flow. The exemplified device is a transistor of type NPN, which is the preferred type for high-speed operations, but the description works equally well for transistors of type PNP. The special characteristics of the present proposed improved device is reduced collector-base voltage dependent capacitance swing and increased collector-base breakdown voltage.

The fabrication flow is started by selecting a highly doped silicon n⁺⁺ substrate **1,** which will form the emitter contact of the structure. The crystal orientation could be, as an example, < 100> for easily obtaining a desired geometry of the device.

As the first step, some device isolation scheme is being applied. In the Figures 8 to 10, three different (simple) ways are shown, depending on the needs for the structure. Since the isolation oxide **2** for this device does not have to be very thick, Figures 8 and 9 will provide enough isolation for this purpose. A fully planar surface with very thick oxide will not be necessary, as in Figure 10. In the following flow, the Figure 9 LOCOS isolation will be used in a sequence of drawings illustrating the fabrication steps.

Layers for the emitter, base, collector and collector contact will then be deposited, as indicated by Figure 11. In one embodiment of the structure according to the present method the n⁺ emitter substrate **1** of Figure 9 may obtain a thin layer of n⁻ by an implantation of boron before proceeding to the further step illustrated in Figure 11. The silicon layer combination and doping levels may be selected to obtain a doping profile as indicated in Figure 3. Typical n-dopants for collector and emitter are arsenic (As) or phosphorous (P) or antimony (Sb), while a typical p-dopant for the base is boron (B). It may be noted that the base may consist of highly doped silicon (p-type boron doped for NPN transistors), but may also consist of a multi-structure of layers, such a Si/SiGe/Si with different dopants added. The initial base layer may also be undoped (intrinsic) and subsequently ion implanted for forming the base doping profile before depositing the collector structure.

The epitaxial silicon layer is deposited blanket (the entire wafer) using conventional methods like MBE or CVD. Then the silicon on top of the LOCOS field oxide is removed using one mask and dry etching. The silicon may also be selectively deposited only on open silicon areas, but this is more demanding on the process window.

Next, part of the silicon is removed to open base contact areas. This constitutes the mesa etch. The mask **8,** may consist of just a photoresist, but depending on the etch as is indicated in Figure 12 also photoresist may be used on top of a layer **9** of oxide, silicon nitride, titanium nitride etc., so that the additional layers also serve as a mask for the silicon etch. The etching may be performed wet, or as a combination of wet and dry. The purpose of the etch is to remove silicon above the base layer and to obtain a rounded or sloped mesa edge, using a KOH (potassium hydroxide) wet etch. Figure 13 illustrates an enlarged view of one of the mesas of Figure 12. In Figure 13 also a thin n- buffer layer is visible on top of the emitter n⁺ region below the p⁺ base region.

After etching the mask **10** is removed. The metalization is then started by depositing an insulating low-temperature oxide layer **12** (e.g. TEOS) over the structure and etching contact holes **13** to the collector and base contact areas, as shown in Figure 15. To ensure low contact resistance to the silicon, a self-aligned silicide layer may be used after etching of contact holes (e.g. PtSi).

The metalization is continued by forming metal layers **16, 17** on top of the structure. This can be sputtered aluminum, which is dry etched as in standard silicon IC processing. It can also be sputtered and electroplated TiW/Au, which has been applied for our high voltage RF-Power devices, and has been described in U.S. Patent No. 5,821,620, which is hereby incorporated by reference, or using a lift-off method or any other common method of metalization,

The device structure is finished by depositing a passivation layer **15,** which serves as a protection for mechanical scratches as well to hinder long-time degradation because of moisture etc. This protection may typically be oxide or nitride and oxide. The protection is removed on bond pad areas using a mask and standard dry etching techniques. The final structure is shown in Figure 17.

The process flow of the inventive silicon power device can be summarized by the following 17 fabrication steps, including only 6 masks which is also shown in the flow chart of Figure 17:
1. Start: Selection of starting material.
2. Device isolation. For a LOCOS isolation scheme: pad oxide growth, silicon nitride deposition, LOCOS mask (MASK #1), LOCOS nitride dry etch, LOCOS field oxidation, nitride etch, pad oxide etch.
3. Epitaxial deposition of emitter/base/collector stack. (MBE or CVD).
4. Etching of deposited silicon on field-oxide areas (MASK #2). (Dry etching.)
5. Etching of base-collector mesa (MASK #3). Wet etching.
6. Deposition of TEOS isolation for metalization.
7. Etching of contacts (MASK #4). (Dry or wet etch.)
8. Formation of silicide in contact areas. (Several methods available.)
9. Formation of metalization (MASK #5). (Several methods available.)
10. Deposition of final passivation layer. SiO₂ and/or SiN.
11. Etching of bond pad openings (MASK #6). (Dry etching.)

By using this structure, and by purposely selecting mesa etching parameters using a wet KOH etch and assuring certain crystal/device orientations, the desired shaped collector will be achieved. In a paper by J. - S. Rieh, L. -H. Lu, L. P. B. Katehi, P. Bhattacharya, E. T. Croke, G. E. Ponchak and S. A. Alterovitz, ("X- and Ku-Band Amplifiers Based on Si/SiGe HBT's and Micromachined Lumped Components", IEEE Transactions On Microwave Theory And Techniques, Vol. MTT-46, p. 685, May 1998), a shaped emitter structure using KOH wet etching is described. According to a Figure 2 of Rieh et al. is demonstrated how in that case the emitter shape is maximized when the orientation of the structure is selected to be in the <110> direction on a < 100> substrate. In the present invention, the processing steps described by Rieh et al. for etching his emitter are in a modified way applied to the process sequence described above to obtain a desired shaped collector structure.

The proposed invention will reduce the collector-base voltage-dependent capacitance swing and increase the collector-base breakdown voltage.

There are a number of related device structures, for example the thyristor and the insulated gate bipolar transistor, that also may have collector regions of similar type. All of these may benefit from parameter improvements mentioned above.

Hot carrier noise is known to depend strongly on the carrier velocity distribution and will be reduced when the electric field variations are smaller. Hot carrier noise is of increasing importance for scaled down devices subject to larger electric fields.

It will be understood by those skilled in the art that various modifications and changes may be made to the present invention without departure from the scope thereof, which is defined by the appended claims.

## Claims

1. A method to reduce the base-collector capacitance swing and increase the collector-to-base breakdown voltage in a bipolar high-frequency transistor comprising the steps of
selecting a highly doped silicon <100> substrate (1) of a first doping forming a transistor emitter region;
depositing a first layer (5) of a second doping for a base/collector structure;
depositing a second layer (6) and a third layer (7) of the first doping for the base/collector structure;
forming a collector mesa structure by removing silicon on base contact areas thereby selecting an etching method to the form of the collector to be made narrowest at the collector contact surface, thereby creating a bipolar collector-up high frequency transistor with a shaped collector, **characterized by** forming the collector mesa structure by a wet KOH etching while orienting the structure in a <110> direction such that the etch forms a trapezoid collector mesa structure.

2. The method of claim 1, **characterized by** the further step of
selecting a crystal device orientation to be in a < 100> direction.

3. The method of claim 1, **characterized by** the further steps of
depositing an insulating low-temperature oxide layer (12) and
creating contact holes (13) to collector and base areas;
masking and forming metalization layers (16, 17) down into the contact holes interconnecting the bas e and collector areas, respectively, and
depositing a passivation layer (15) forming openings for the further creating of base and collector contacts and bonding pads for respective base and collector metalization layers forming the "etch-up" bipolar collector-up high frequency transistor.

4. The method of claim 1, **characterized by** the further step of
depositing the first type of doping as a doping of type P for the first layer (5), and the second type of doping as a doping of type N for the second and third layers (6,7), respectively, for creating an NPN bipolar transistor structure.

5. The method of claim 1, **characterized by** the further step of
depositing the first type of doping as a doping of type N for the first layer (5), and the second type of doping as a doping of type P for the second and third layers (6, 7), respectively, for creating a PNP bipolar transistor structure.

6. The method of claim 1, **characterized by** the further step of
creating a transistor structure with a component isolation by introducing a standard isolation step, for instance a LOCOS step.

7. The method of claim 1, **characterized by** the further step of
introducing an extra step with an n⁻ implantation before the step of depositing the base.

8. The method of claim 1, **characterized by** the further step of
depositing the base as a multi-structure layer, such as Si/SiGe/Si with different dopants, before depositing a layer for forming the collector mesa structure.

9. The method of claim 1, **characterized by** the further step of
depositing the base as an undoped intrinsic layer being subsequently implanted for forming the base profile, before depositing a layer for forming the collector mesa structure.

## Patentansprüche

1. Verfahren zum Reduzieren des Basis-Kollektor-Kapazitätsausschlags und zum Vergrößern der Kollektor-Basis-Durchschlagspannung in einem Bipolar-Hochfrequenz-Transistor, umfassend die folgenden Schritte:
Wählen eines hochdotierten <100>-Siliziumsubstrats (1) mit einer ersten Dotierung, ein Transistoremittergebiet bildend;
Abscheiden einer ersten Schicht (5) mit einer zweiten Dotierung für eine Basis-Kollektor-Struktur;
Abscheiden einer zweiten Schicht (6) und einer dritten Schicht (7) mit der ersten Dotierung für die Basis-Kollektor-Struktur;
Bilden einer Kollektormesastruktur durch Entfernen von Silizium auf Basiskontaktbereichen, wodurch ein Ätzverfahren ausgewählt wird für die Form des Kollektors, der an der Kollektorkontaktoberfläche am schmalsten hergestellt werden soll, wodurch ein Bipolar-Hochfrequenz-Transistor mit obenliegendem Kollektor mit einem geformten Kollektor hergestellt wird, **gekennzeichnet durch** Bilden der Kollektormesastruktur **durch** ein nasses KOH-Ätzen, während die Struktur in einer <110>-Richtung orientiert ist, so dass die Ätzung eine trapezförmige Kollektormesastruktur bildet.

2. Verfahren nach Anspruch 1, **gekennzeichnet durch** den weiteren Schritt:
Wählen einer Kristalleinrichtungsorientierung in einer <100>-Richtung.

3. Verfahren nach Anspruch 1, **gekennzeichnet durch** die weiteren Schritte:
Abscheiden einer isolierenden Niedertemperaturoxidschicht (12) und Herstellen von Kontaktlöchern (13) zu Kollektor- und Basisbereichen;
Maskieren und Ausbilden von Metallisierungsschichten (16, 17) hinunter in die Kontaktlöcher, die Basis- bzw. Kollektorbereiche zusammenschaltend, und
Abscheiden einer Passivierungsschicht (15), Öffnungen für das weitere Herstellen von Basis- und Kollektorkontakten und Bondpads für jeweilige Basis- und Kollektormetallisierungsschichten bildend, den Bipolar-Hochfrequenz-Transistor mit obenliegenden Kollektor und Aufwärtsätzung bildend.

4. Verfahren nach Anspruch 1, **gekennzeichnet durch** den weiteren Schritt:
Abscheiden der ersten Art von Dotierung als eine Dotierung vom Typ P für die erste Schicht (5) und der zweiten Art von Dotierung als eine Dotierung vom Typ N für die zweite bzw. dritte Schicht (6, 7), um eine NPN-Bipolartransistorstruktur herzustellen.

5. Verfahren nach Anspruch 1, **gekennzeichnet durch** den weiteren Schritt:
Abscheiden der ersten Art von Dotierung als eine Dotierung vom Typ N für die erste Schicht (5) und der zweiten Art von Dotierung als eine Dotierung vom Typ P für die zweite bzw. dritte Schicht (6, 7), um eine PNP-Bipolartransistorstruktur herzustellen.

6. Verfahren nach Anspruch 1, **gekennzeichnet durch** den weiteren Schritt:
Herstellen einer Transistorstruktur mit einer Komponentenisolation **durch** Einführen eines Standardisolationsschritts, beispielsweise eines LOCOS-Schritts.

7. Verfahren nach Anspruch 1, **gekennzeichnet durch** den weiteren Schritt:
Einführen eines zusätzlichen Schritts mit einer n⁻ Implantation vor dem Schritt des Abscheidens der Basis.

8. Verfahren nach Anspruch 1, **gekennzeichnet durch** den weiteren Schritt:
Abscheiden der Basis als eine Mehrstrukturschicht wie etwa Si/SiGe/Si mit verschiedenen Dotierstoffen vor dem Abscheiden einer Schicht zum Bilden der Kollektormesastruktur.

9. Verfahren nach Anspruch 1, **gekennzeichnet durch** den weiteren Schritt:
Abscheiden der Basis als eine undotierte Eigenleitungsschicht, in die danach implantiert wird, um das Basisprofil zu bilden, bevor eine Schicht zum Bilden der Kollektormesastruktur abgeschieden wird.

## Revendications

1. Procédé pour réduire l'oscillation de capacité base-collecteur et augmenter la tension de claquage entre collecteur et base dans un transistor bipolaire à haute fréquence, comprenant les étapes consistant à :
sélectionner un substrat de silicium <100> fortement dopé (1) ayant un premier dopage formant une région d'émetteur de transistor ;
déposer une première couche (5) d'un second dopage pour une structure de base/collecteur ;
déposer une seconde couche (6) et une troisième couche (7) du premier dopage pour la structure de base/collecteur ;
former une structure de mesa de collecteur en enlevant du silicium présent sur des zones de contact de base,
en sélectionnant ainsi une méthode de gravure afin de former le collecteur de manière à ce qu'il soit réalisé de la façon la plus étroite au niveau de la surface de contact de collecteur, en créant ainsi un transistor bipolaire à haute fréquence à collecteur haut avec un collecteur mis en forme, **caractérisé par** le fait de former la structure de mesa de collecteur par gravure humide au KOH tout en orientant la structure dans une direction <110> de manière à ce que la gravure forme une structure de mesa de collecteur trapézoïdale.

2. Procédé selon la revendication 1, **caractérisé par** l'étape supplémentaire consistant à :
sélectionner une orientation du dispositif cristallin afin qu'elle soit dans une direction <100>.

3. Procédé selon la revendication 1, **caractérisé par** l'étape supplémentaire consistant à :
déposer une couche d'oxyde isolant basse température (12) et créer des trous de contact (13) vers des zones de collecteur et de base ;
masquer et former des couches de métallisation (16, 17) descendant à l'intérieur des trous de contact et
interconnectant respectivement les zones de base et de collecteur, et
déposer une couche de passivation (15) en formant des ouvertures pour la création supplémentaire de contacts de base et de collecteur et de plots de connexion destinés à des couches de métallisation de base et de collecteur respectives formant le transistor bipolaire à haute fréquence à collecteur haut et à "gravure vers le haut".

4. Procédé selon la revendication 1, **caractérisé par** l'étape supplémentaire consistant à :
déposer le premier type de dopage en tant que dopage de type P pour la première couche (5), et le second type de dopage en tant que dopage de type N pour les seconde et troisième couches (6, 7), respectivement, afin de créer une structure de transistor bipolaire NPN.

5. Procédé selon la revendication 1, **caractérisé par** l'étape supplémentaire consistant à :
déposer le premier type de dopage en tant que dopage de type N pour la première couche (5), et le second type de dopage en tant que dopage de type P pour les seconde et troisième couches (6, 7), respectivement, afin de créer une structure de transistor bipolaire PNP.

6. Procédé selon la revendication 1, **caractérisé par** l'étape supplémentaire consistant à :
créer une structure de transistor avec une isolation entre composants en introduisant une étape d'isolation normalisée, par exemple une étape LOCOS.

7. Procédé selon la revendication 1, **caractérisé par** l'étape supplémentaire consistant à :
introduire une étape supplémentaire avec une implantation n⁻ avant l'étape de dépôt de la base.

8. Procédé selon la revendication 1, **caractérisé par** l'étape supplémentaire consistant à :
déposer la base sous la forme d'une couche à structure multiple, telle que du Si/SiGe/Si avec différents dopants, avant de déposer une couche destinée à former la structure de mesa de collecteur.

9. Procédé selon la revendication 1, **caractérisé par** l'étape supplémentaire consistant à :
déposer la base en tant que couche intrinsèque non dopée qui est ensuite implantée afin de former le profil de base, avant de déposer une couche destinée à la formation de la structure de mesa de collecteur.
